# EUROPEAN PATENT APPLICATION

(11) **EP 4 621 673 A1**
(43) Date of publication of application: **24.09.2025**
(21) Application number: 25158220.1
(22) Date of filing: 17.02.2025
(51) Int. Cl.: G06Q 10/04

(54) **MEASURE SPECIFYING PROGRAM, MEASURE SPECIFYING METHOD, AND INFORMATION PROCESSING DEVICE**

(30) Priority: 22.03.2024 JP 2024047184
(71) Applicant: FUJITSU LIMITED, Kawasaki-shi, Kanagawa 211-8588 (JP)
(72) Inventor: TOMIMORI, Hideki, 211-8588 Kawasaki-shi, Kanagawa (JP); SUZUKI, Tatsuya, 211-8588 Kawasaki-shi, Kanagawa (JP)
(74) Representative: Hoffmann Eitle

(57) **Abstract**

A measure specifying program for causing a computer to execute processing includes generating a digital twin that reproduces a state of a water area in a real world on a virtual space, performing a simulation with the generated digital twin, specifying a measure to be applied, from among a plurality of measure candidates, based on a result of the performed simulation, and displaying information regarding the specified measure on a display screen.

## Description

### FIELD

The embodiments discussed herein are related to a measure specifying program, a measure specifying method, and an information processing device.

### BACKGROUND

Measure analysis has been needed in various situations, and the measure analysis has been performed using a simulation to specify an optimal measure.

### Citation List

### Patent document

Japanese Laid-open Patent Publication No. 2023-182560

### SUMMARY

### TECHNICAL PROBLEM

However, the related art can obtain only a simulation result under a specific condition because a simulation using a preset calculation formula or the like is performed. It is hard to say that simulation data with high reproducibility can be provided. Furthermore, although it is considered to plan a measure using the simulation results, since it depends on the simulation results, it is not possible to plan a measure with a high introduction effect.

According to one aspect, an object is to provide a measure specifying program, a measure specifying method, and an information processing device that can improve accuracy of measure analysis.

### SOLUTION TO PROBLEM

According to an aspect of the embodiments, a measure specifying program for causing a computer to execute processing includes generating a digital twin that reproduces a state of a water area in a real world on a virtual space, performing a simulation with the generated digital twin, specifying a measure to be applied, from among a plurality of measure candidates, based on a result of the performed simulation, and displaying information regarding the specified measure on a display screen.

### ADVANTAGEOUS EFFECTS OF INVENTION

According to one embodiment, accuracy of measure analysis can be improved.

### BRIEF DESCRIPTION OF DRAWINGS

FIG. 1 is a diagram for explaining an overall configuration example of an optimal measure specifying system according to a first embodiment;
FIG. 2 is a diagram for explaining a definition of an ocean;
FIG. 3 is a functional block diagram illustrating a functional configuration of an information processing device according to the first embodiment;
FIG. 4 is a diagram for explaining a selection example of a development candidate;
FIG. 5 is a diagram for explaining an example of a development pattern;
FIGs. 6A and 6B are diagrams for explaining estimation of an ocean environment;
FIG. 7 is a diagram for explaining a result example of a simulation of an alga amount;
FIG. 8 is a diagram for explaining a method for estimating a factor;
FIG. 9 is a diagram for explaining the method for estimation the factor;
FIG. 10 is a diagram for explaining a result of factor estimation;
FIG. 11 is a diagram for explaining a scoring result;
FIG. 12 is a diagram for explaining a display example;
FIG. 13 is a flowchart illustrating a flow of overall processing;
FIG. 14 is a flowchart illustrating a flow of simulation processing;
FIG. 15 is a flowchart illustrating a flow of measure evaluation processing;
FIG. 16 is a diagram for explaining a flow of processing for specifying a measure to be applied;
FIGs. 17A to 17C are diagrams for explaining another example of measure evaluation; and
FIG. 18 is a diagram for explaining a hardware configuration example.

### DESCRIPTION OF EMBODIMENTS

Hereinafter, embodiments of a measure specifying program, a measure specifying method, and an information processing device disclosed in the present application will be described in detail with reference to the drawings. Note that the present invention is not limited by the embodiment.

### [First Embodiment]

### (Overall Configuration)

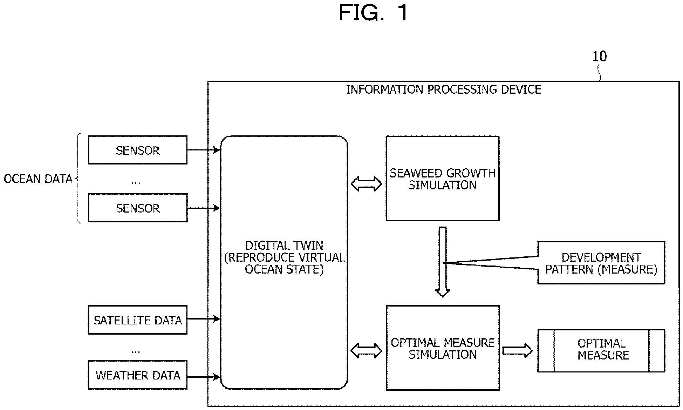

FIG. 1 is a diagram for explaining an overall configuration example of an optimal measure specifying system according to a first embodiment. As illustrated in FIG. 1, the optimal measure specifying system is a system that includes a plurality of sensors and an information processing device 10 and performs, for example, a simulation regarding growth of seaweeds and development of a seaweed bed.

The multiple sensors are various sensors used to collect sea area data (ocean data). For example, the plurality of sensors includes various sensors that measure the sea area data such as an underwater drone including a camera that images a state in the sea, a luminous intensity sensor that measures a luminous intensity in the sea, a temperature sensor that measures a water temperature, or a concentration sensor that measures salt concentration.

The information processing device 10 acquires actual sea area data, accurately measures a volume of the seaweeds and a density at the seaweed bed where the seaweeds grow, performs modeling, and reproduces a marine state. Then, the information processing device 10 is an example of a computer that simulates an absorption effect of carbon dioxide (CO₂) and an environmental effect about environmental measures such as regeneration or development of the seaweed bed and develops a plan based on the simulation.

The information processing device 10 generates a digital twin that reproduces a state of a water area in the real world on a virtual space, and performs a simulation with the generated digital twin. Next, the information processing device 10 specifies a measure to be applied, among a plurality of measure candidates, based on the result of the performed simulation. Then, the information processing device 10 displays information regarding the specified measure on a display screen.

More specifically, the information processing device 10 generates a digital twin that reproduces a state of a sea area in the real world on the virtual space, and performs a simulation regarding a state of a target to which the measure is applied, using the state of the sea area, with the generated digital twin. Then, the information processing device 10 specifies a measure to be applied from among the plurality of measure candidates, based on a result of the performed simulation and displays information regarding the specified measure to be applied on the display screen.

For example, the information processing device 10 acquires the sea area data from each of the plurality of sensors, shapes of regions and oceans from satellite data, weather information from a weather sensor, or the like and generates the digital twin that reproduces a virtual ocean state, using these pieces of information.

Then, the information processing device 10 performs a seaweed growth simulation on the digital twin for each of a plurality of seaweed development patterns, that is, an example of the measures. Moreover, the information processing device 10 executes an environment simulation at the time of developing the seaweed on the digital twin. Thereafter, the information processing device 10 evaluates each development pattern of the seaweed, using an environment simulation result and presents an optimal seaweed development pattern to a user.

In this way, since the information processing device 10 can simulate various measures in consideration of changes in the environment and the sea area, on the digital twin that reproduces an actual sea area, accuracy of measure analysis can be improved.

### (Explanation of Terms)

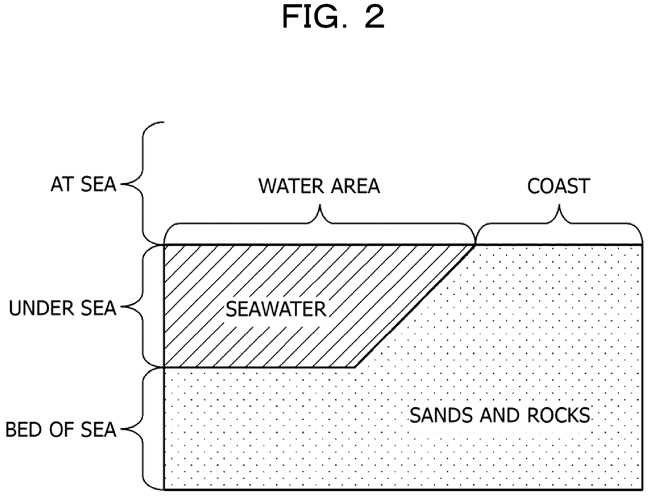

A definition of an ocean and terms used in the present embodiment will be described. FIG. 2 is a diagram for explaining the definition of the ocean. In FIG. 2, the ocean is illustrated. A region with seawater is defined as a water area, a region on a land side with no seawater is defined as a coast, a region above the sea surface is defined as at sea, a region with seawater from the sea surface to a ground where sands and rocks are placed is defined as under the sea, and a region, with no seawater, including the ground where sands and rocks are placed and an earth crust is defined as the bed of the sea.

Furthermore, as an example of terms used in the present embodiment, a space indicates a three-dimensional shape, a water depth, or the like, and an artificial object indicates a building, a navigate vessel, or the like. Furthermore, the measure indicates a pattern indicating a region in the sea area where the seaweed bed is developed, and a parameter in the measure includes a seaweed species, a period, or the like.

Furthermore, as an example of the ocean data used in the present embodiment, an environment indicates a temperature, brightness, an atmospheric pressure, a water pressure, pH, a precipitation, an organism indicates biological species, biomass, or the like, and a substance indicates nutrient salt, a rock elemental content, a gas concentration, or the like. Note that these pieces of ocean data are measured as time-series data.

### (Functional Configuration)

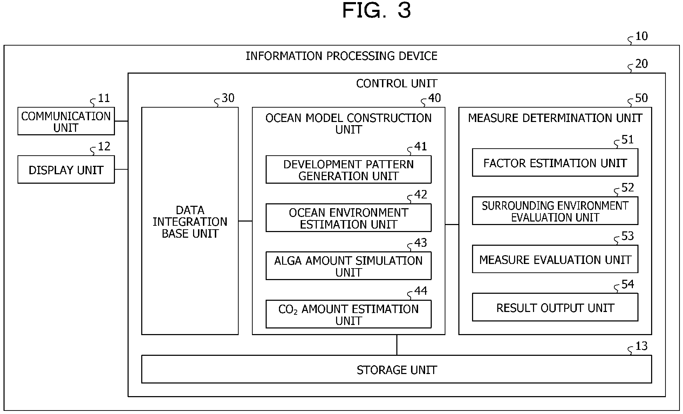

FIG. 3 is a functional block diagram illustrating a functional configuration of the information processing device 10 according to the first embodiment. As illustrated in FIG. 3, the information processing device 10 includes a communication unit 11, a display unit 12, a storage unit 13, and a control unit 20.

The communication unit 11 is a processing unit that controls communication with another device and, for example, is implemented by a communication interface or the like. For example, the communication unit 11 acquires the ocean data in time series from various sensors.

The display unit 12 is a processing unit that displays and outputs various types of information, and is implemented by, for example, a display, a touch panel, or the like. For example, the display unit 12 outputs information regarding the specified optimal measure, by the control unit 20 to be described later.

The storage unit 13 is a processing unit that stores various types of data, programs executed by the control unit 20, and the like and, for example, is implemented by a memory, a hard disk, or the like. For example, the storage unit 13 stores a development pattern to be described later, a program and a parameter to be used for the digital twin, the ocean data acquired by the communication unit 11, a machine learning model used by the control unit 20, or the like.

The control unit 20 is a processing unit that takes overall control of the information processing device 10, and is implemented by, for example, a processor or the like. This control unit 20 includes a data integration base unit 30, an ocean model construction unit 40, and a measure determination unit 50. Note that the data integration base unit 30, the ocean model construction unit 40, and the measure determination unit 50 are implemented by an electronic circuit executed by the processor, a process executed by the processor, or the like.

The data integration base unit 30 is a processing unit that generates a digital twin that reproduces the state of the sea area in the real world on the virtual space. For example, the data integration base unit 30 adjusts times series of time-series data of the ocean data acquired from various sensors, the weather information acquired from an external sensor, or the like and generates a digital twin time-synchronized with a current sea area. Furthermore, the data integration base unit 30 can maintain the digital twin following a state of the sea area in the real world that changes from moment to moment, by continuously changing and correcting the digital twin using the time-series data.

The ocean model construction unit 40 is a processing unit that includes a development pattern generation unit 41, an ocean environment estimation unit 42, an alga amount simulation unit 43, and a CO₂ amount estimation unit 44 and performs a simulation of seaweed growth and seaweed bed development simulation, using the state of the sea area on the digital twin.

The development pattern generation unit 41 is a processing unit that generates the development pattern that is a measure. Specifically, the development pattern generation unit 41 generates the plurality of development patterns, by receiving a position and a range of the seaweed bed to be developed and a type and a development period of the seaweed to be developed from the user, or automatically selecting them.

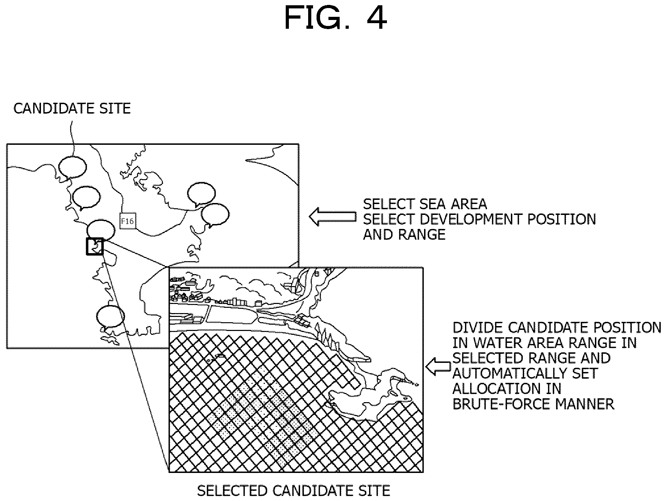

FIG. 4 is a diagram for explaining a selection example of a development candidate. As illustrated in FIG. 4, when receiving the selection of the region from the user, the development pattern generation unit 41 displays map data of a sea area including a candidate site set in that region. Then, when receiving selection of a development position and a development range on the map data, the development pattern generation unit 41 divides a water area range in the selected range into meshes and automatically sets the divided mesh region as a development candidate position in a brute-force manner.

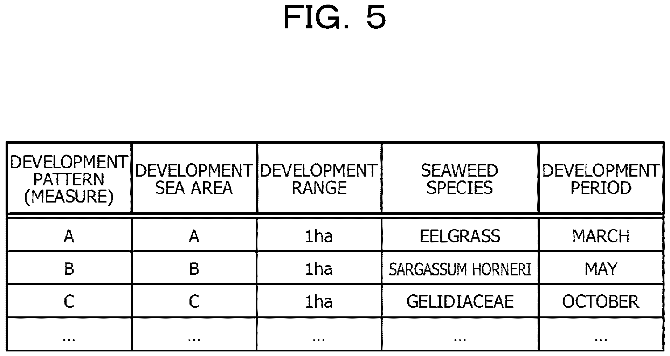

Here, the generated development pattern is described. FIG. 5 is a diagram for explaining an example of the development pattern. As illustrated in FIG. 5, the development pattern generation unit 41 generates "development sea area, development range, seaweed species, and development period" as the development pattern. The "development sea area" indicates a sea area where seaweeds are developed, the "development range" indicates a range where the seaweeds are developed, the "seaweed species" indicates a species of the seaweeds to be developed, and the "development period" indicates a period of development. In the example in FIG. 5, as a "development pattern A", it is indicated that a measure for developing "eelgrass" in "March" in a "sea area A" within a range of "1 ha" is generated.

The ocean environment estimation unit 42 is a processing unit that estimates various types of environment information to be input into an alga growth model used for an alga growth simulation, using the digital twin. Specifically, the ocean environment estimation unit 42 estimates an ocean state "temperature, brightness, atmospheric pressure, water pressure, weight, pH, and precipitation" or the like in the future when a development period designated in advance ends, from a current ocean state "bottom quality and water depth of ocean bed corresponding to position of seaweed bed candidate" or the like. More specifically, the ocean environment estimation unit 42 estimates time-series data of a light amount, a water temperature, and a nutrient salt concentration from the present to the future (for example, after five years).

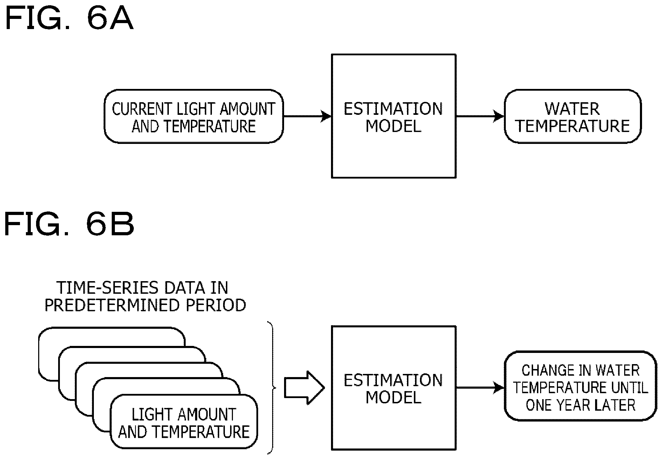

Furthermore, the ocean environment estimation unit 42 can realize a future ocean state with the digital twin, by estimating the future ocean state, using the machine learning model on the digital twin. FIGs. 6A and 6B are diagram for explaining estimation of an ocean environment. As illustrated in FIG. 6A, the ocean environment estimation unit 42 can input data of a current light amount and temperature into an estimation model on the digital twin and predict future water temperature data. Furthermore, as illustrated in FIG. 6B, the ocean environment estimation unit 42 can input light amount and temperature data in a predetermined period such as one month or one year into the estimation model and estimate a change in the water temperature data until one year later. Note that the estimation model here is merely an example, and an input and an output can be changed by a training method or the like.

The alga amount simulation unit 43 is a processing unit that simulates the growth of the seaweed in each development pattern or the like, on the digital twin using the environment information estimated by the ocean environment estimation unit 42. For example, the alga amount simulation unit 43 inputs the future ocean state "temperature, brightness, atmospheric pressure, water pressure, weight, pH, and precipitation" into a physical model (alga growth model) obtained by modeling the growth of the seaweed and predicts a biomass amount of the alga at a future time after the development period.

In this way, the alga amount simulation unit 43 executes the alga growth simulation for each development pattern, and acquires information regarding whether or not algae to be developed grow, how much the development range of the algae to be developed is extended or narrowed, whether or not the size of the algae to be developed increases or decreases, or the like. Note that, as the alga growth model, an existing model can be used, and a model to be used is not limited.

The CO₂ amount estimation unit 44 is a processing unit that estimates a CO₂ absorption amount from the biomass amount of the alga at the future time simulated by the alga amount simulation unit 43, for each development pattern. For example, the CO₂ amount estimation unit 44 estimates a CO₂ absorption amount of the seaweed bed to be developed, using a seaweed bed area * an absorption coefficient per unit area.

Note that the seaweed bed area is a development range of the alga at the time when each development pattern is generated or a development range of the alga at the future time included in the simulation result, and the absorption coefficient is a constant set for each seaweed species. Furthermore, a calculated amount of the CO₂ absorption amount is not limited to "seaweed bed area * absorption coefficient per unit area", other calculation formulas can be used, and a calculation formula different for each seaweed species may be used.

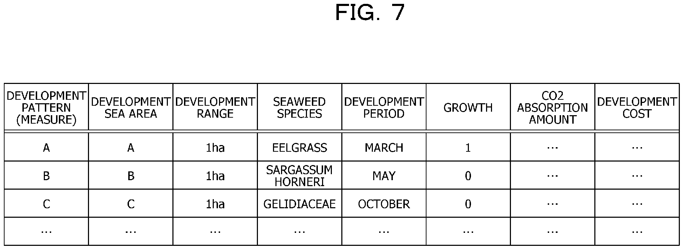

FIG. 7 is a diagram for explaining a result example of the simulation of the alga amount. As illustrated in FIG. 7, through processing by the alga amount simulation unit 43 and the CO₂ amount estimation unit 44, "growth, CO₂ absorption amount, and development cost" are calculated for each development pattern. Here, the "growth" is information set by the alga amount simulation unit 43 and indicates whether or not a target seaweed is grown from the present to a time point when the development period has elapsed. In a case where the seaweed is grown, "1" is set, and in a case where the seaweed is not grown, "0" is set. The "CO₂ absorption amount" indicates the CO₂ absorption amount calculated by the CO₂ amount estimation unit 44. The "development cost" is information calculated by the alga amount simulation unit 43 or information set by the user and is cost obtained by collecting cost required for measures (development pattern), the number of people required for executing the measures, or the like.

The measure determination unit 50 is a processing unit that includes a factor estimation unit 51, a surrounding environment evaluation unit 52, a measure evaluation unit 53, and a result output unit 54 and evaluates a key measure.

The factor estimation unit 51 is a processing unit that extracts a common correlation relationship between the simulation result (growth of seaweed bed = CO₂ absorption increase) and each parameter included in the measure with a classification model and specifies a causal relationship of the parameter using the extracted result and a causal discovery model.

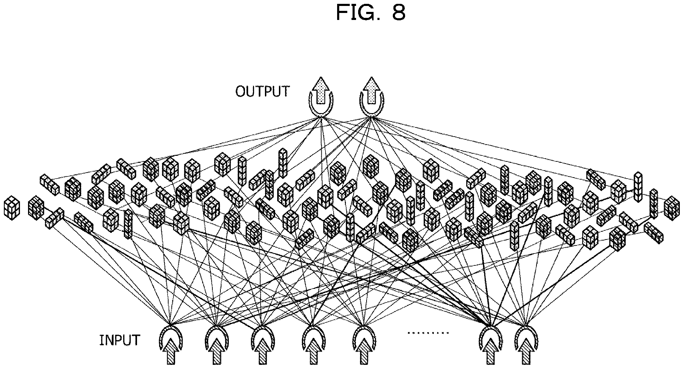

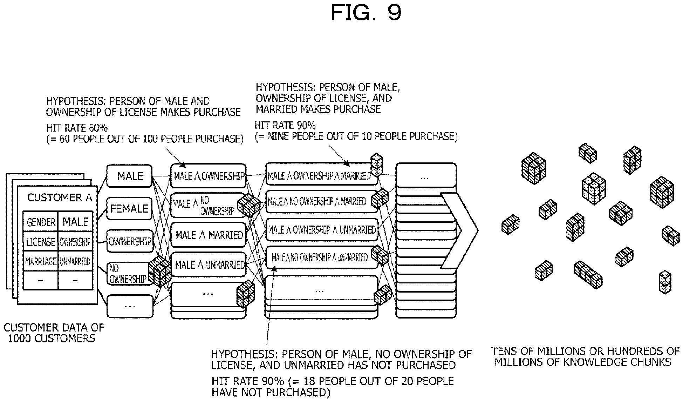

Here, the classification model is briefly described. FIGs. 8 and 9 are diagrams for explaining a method for estimating a factor. The classification model illustrated in FIG. 8 is a model that has trained a combination of a hypothesis and an importance level. Typically, deep learning achieves accuracy improvement by stacking multiple layers of neural networks imitating the structure of the neural circuit of the human brain and refining one model, and thus it is a complex model that may not be understood by humans. Meanwhile, as illustrated in FIG. 8, the classification model is a highly accurate classification model that combines data items, which are exemplary attribute values, to extract a large number of hypotheses and adjusts importance levels of the hypotheses (knowledge chunks (may be simply referred to as "chunks" hereinafter)). The knowledge chunk is a simple model that may be understood by humans, and is a model that describes a hypothesis that may be established as an input/output relationship in a logical expression.

Specifically, the factor estimation unit 51 sets combination patterns of all data items of input data as the hypotheses (chunks), and determines the importance level of the hypothesis based on a hit rate of a label for each of the hypotheses. Then, the factor estimation unit 51 constructs a model based on the labels (objective variables) and the plurality of knowledge chunks that have been extracted. At this time, the factor estimation unit 51 takes control in such a manner that the importance level is lowered in a case where the items included in the knowledge chunk contain many overlaps with items of another knowledge chunk.

A specific example will be described with reference to FIG. 9. Here, an example of determining a customer who purchases a certain product or service will be considered. Customer data includes various items (attribute values) such as "gender", "presence/absence of license", "marriage", "age", or "annual income". All combinations of those items are set as hypotheses, and the importance level of each of the hypotheses is considered. For example, there are 10 customers who fit the hypothesis in which the items ""male", "ownership", and "married"" are combined in the data. If 9 people out of those 10 people have purchased the product or the like, a hypothesis "a person of "male", "ownership", and "married" makes a purchase" with a high hit rate is set, and this is extracted as a knowledge chunk. Note that a label, that is, an objective variable, is set to be binary representation of whether or not the product has been purchased here as an example.

Meanwhile, there are 100 customers who fit the hypothesis in which the items ""male" and "ownership"" are combined in the data. In a case where only 60 people out of those 100 people have purchased the product or the like, the hit rate of purchasing is 60%, which is lower than a threshold value (e.g., 80), and thus a hypothesis "a person of ""male" and "ownership" makes a purchase" with a low hit rate is set, and this is not extracted as a knowledge chunk.

Furthermore, there are 20 customers who fit the hypothesis in which the items ""male", "no ownership", and "unmarried"" are combined in the data. In a case where 18 people out of those 20 people have not purchased the product or the like, the hit rate of non-purchasing is 90%, which is equal to or higher than a threshold value (e.g., 80), and thus a hypothesis "a person of "male", "no ownership", and "unmarried" does not make a purchase" with a high hit rate is set, and this is extracted as a knowledge chunk.

In this manner, the factor estimation unit 51 extracts tens of millions or hundreds of millions of knowledge chunks that support purchasing and knowledge chunks that support non-purchasing, and executes model training. The model trained in this manner enumerates combinations of features as hypotheses (chunks), an importance level, which is an exemplary likelihood indicating certainty, is added to each of the hypotheses, the sum of the importance levels of the hypotheses that appear in input data is set as a score, and when the score is equal to or higher than a threshold value, it is output as a positive example.

That is, the score is an index indicating the certainty of the state, and is the total value of the importance levels of the chunks in which all features belonging thereto are satisfied among the chunks (hypotheses) generated by individual models. For example, it is assumed that, in a state where a chunk A is associated with "importance level: 20, features (A1, A2)", a chunk B is associated with "importance level: 5, feature (B1)", a chunk C is associated with "importance level: 10, features (C1, C2)", and data items of the determination target data include (A1, A2, B1, and C1). At this time, all the features of the chunk A and the chunk B appear, and the score is "20 + 5 = 25", accordingly. Furthermore, the features here correspond to a user action and the like.

As described above, the factor estimation unit 51 specifies the causal relationship, using the causal discovery model from the hypothesis extracted in this way. Specifically, the information processing device 10 specifies a causal relationship between a combination of explanatory variables (hypothesis) and an objective variable. For example, the factor estimation unit 51 exhaustively checks combinations of feature mounts using a technology of analyzing which factor is a cause and which factor is a result by analyzing mutual influence when two factors mutually change, and extracts a causal relationship for each condition group.

More specifically, the factor estimation unit 51 extracts a degree of influence or the like given by each combination (hypothesis) on each condition set as the objective variable, thereby generating a causal relationship between each item included in the measure and the objective variable. For example, the factor estimation unit 51 sets a "combination that largely affects on objective variable", among each of the extracted combinations, as a grouping rule of original data. Then, by analyzing a causal relationship in a specific group, the factor estimation unit 51 individually extracts a causal relationship in which multiple causal relationships are mixed and offset each other to be invisible when viewed as a whole.

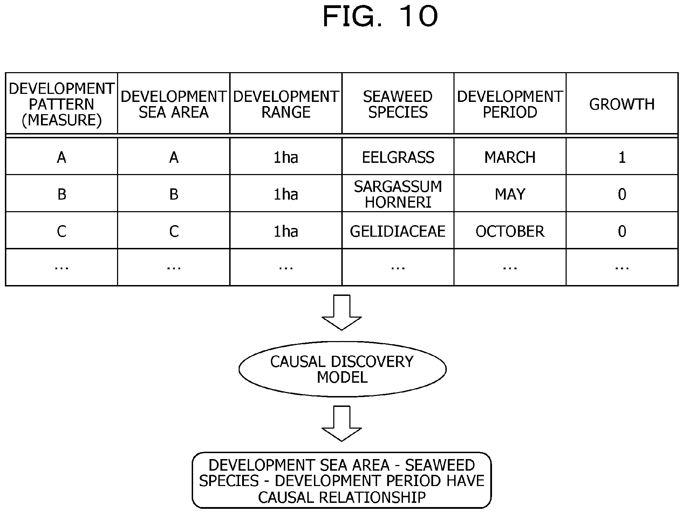

FIG. 10 is a diagram for explaining a result of factor estimation. As illustrated in FIG. 10, when the above technology is applied to the present embodiment, the hypothesis that is a combination of features is the combination of the items included in the measures and corresponds to, for example, "seaweed species and development period", seaweed species, development period, and growth", "development sea area and seaweed species", "development sea area, development range, and seaweed species", or the like. Then, the factor estimation unit 51 specifies a causal relationship between each combination such as "seaweed species and development period", "seaweed species, development period, and growth", "development sea area and seaweed species", "development sea area, development range, and seaweed species", or the like and the objective variable "CO₂ absorption amount". The example in FIG. 10 indicates that "development sea area, seaweed species, and development period" has a high relationship with "CO₂ absorption amount".

Thereafter, the factor estimation unit 51 displays and outputs the specified causal relationship on the display unit 12 or the like. The causal relationship specified in this way is used to determine the measures or to determine the sea area change or the like. For example, in a case where no combination affects the objective variable "CO₂ absorption amount", it is considered to change the sea area. Furthermore, in a case where it is found that "sea area" largely affects the objective variable "CO₂ absorption amount", it is considered to narrow the area to the "sea area" and take the measures again.

Returning to FIG. 3, the surrounding environment evaluation unit 52 is a processing unit that evaluates an environment value of a sea area surrounding a seaweed bed development position, for each development pattern (measure), by the simulation using the digital twin. Specifically, the surrounding environment evaluation unit 52 executes an environment simulation from the time of development to the time when the development ends (future time point), on a key measure, for which the CO₂ absorption amount is expected to be increased by the CO₂ amount estimation unit 44 and of which "CO₂ absorption amount" is equal to or more than a threshold value and scores the environment value.

For example, the surrounding environment evaluation unit 52 executes the environment simulation for calculating a score for a present index of an Ocean health index, using the digital twin and specifies an environment value of a sea area surrounding the seaweed bed development position at the future time point in a case where each measure (development pattern) is executed. More specifically, the surrounding environment evaluation unit 52 evaluates each of items "food, water quality, coastal protection, tourism, economy, marine products, image of place, and biological diversity", as the environment value.

Here, "food" is an increase degree of fish catches in a measure target sea area, "water quality" is an improvement degree of a measure target water quality, and "coastal protection" is a degree of approach to protection of a measure target sea area. "Tourism" is a degree at which the measure target sea area is evaluated as a sightseeing spot, "marine products" indicate an increase degree of marine products in the measure target sea area, "image of place" is an increase degree of favorable rating of a social image of the measure target sea area, and "biological diversity" is an increase degree of species in the measure target sea area.

The measure evaluation unit 53 is a processing unit that calculates a score of each of the CO₂ absorption amount, the development cost, and the environment value, for each measure (development pattern), evaluates each measure, and specifies an optimal measure. Specifically, the measure evaluation unit 53 calculates the score for the simulation result (for example, refer to FIG. 7) by the alga amount simulation unit 43.

For example, the measure evaluation unit 53 normalizes the estimated CO₂ absorption amount, as the score of the CO₂ absorption amount, so that a maximum value of the CO₂ absorption amount for each measure to be compared is a constant value. For example, a maximum value of the score is defined as 500 points.

Furthermore, the measure evaluation unit 53 calculates "distance from coast * seaweed bed area * seaweed species" * (reciprocal of coefficient set according to laying method) as cost of the seaweed bed development and normalizes the calculation result so that the maximum value of the development cost for each measure to be compared is a constant value. Note that the higher the development cost, the smaller the score value.

Furthermore, the measure evaluation unit 53 uses "score for present index of Ocean health index" calculated by the surrounding environment evaluation unit 52, as the score of the environment value. Note that "possibility of small-scale fishery" that is an item difficult to be calculated, and "carbon storage amount" that is originally included in the score are excluded from score targets.

For example, the measure evaluation unit 53 calculates an environment value score for measures "A, D, E, and G", of which "CO₂ absorption amount" is the threshold value, by the CO₂ amount estimation unit 44, among measures "A, B, C, D,..." illustrated in FIG. 7 and executes scoring.

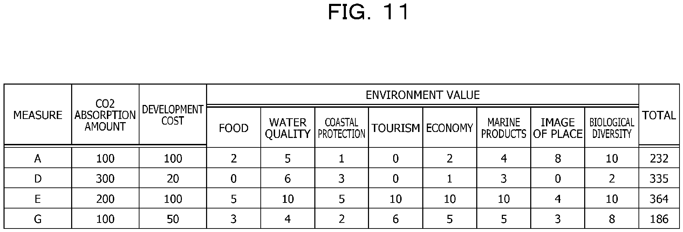

FIG. 11 is a diagram for explaining a scoring result. As illustrated in FIG. 11, the measure evaluation unit 53 calculates "CO₂ absorption amount, development cost, environment value (food, water quality, coastal protection, tourism, economy, marine products, image of place, and biological diversity), and total" for each measure. Evaluation of each evaluation item is higher as the value is larger. In the example in FIG. 11, the measure "A" is evaluated as "CO₂ absorption amount = 100, development cost = 100, environment value (food = 2, water quality = 5, coastal protection = 1, tourism = 0, economy = 2, marine products = 4, image of place = 8, and biological diversity = 10), and it is indicated that a total of the evaluation values is "232".

The measure evaluation unit 53 specifies the measure "E" with the highest score as the optimal measure, among a total score "232" of the measure "A", a total score "335" of the measure "D", a total score "364" of the measure "E", and a total score "186" of the measure "G" illustrated in FIG. 11.

The result output unit 54 is a processing unit that outputs a result evaluated by the measure evaluation unit 53 to the display unit 12. For example, the result output unit 54 can output all the evaluated measures and output only the specified optimal measure. Furthermore, the result output unit 54 can display an output result of a causal relationship model or the like.

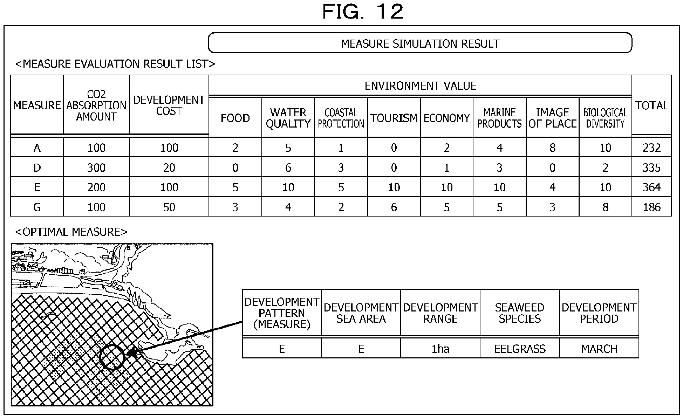

FIG. 12 is a diagram for explaining a display example. As illustrated in FIG. 12, the result output unit 54 displays an evaluation result of the key measure that can expect an increase in the CO₂ absorption amount, evaluated by the measure evaluation unit 53, as the measure simulation result. Furthermore, the result output unit 54 outputs an evaluation result of the optimal measure "E" as associating a developed region of the optimal measure "E", with map data of the sea area designated as the measure target. Note that the display example is merely an example, and display items or the like can be arbitrarily changed.

### (Flow of Overall Processing)

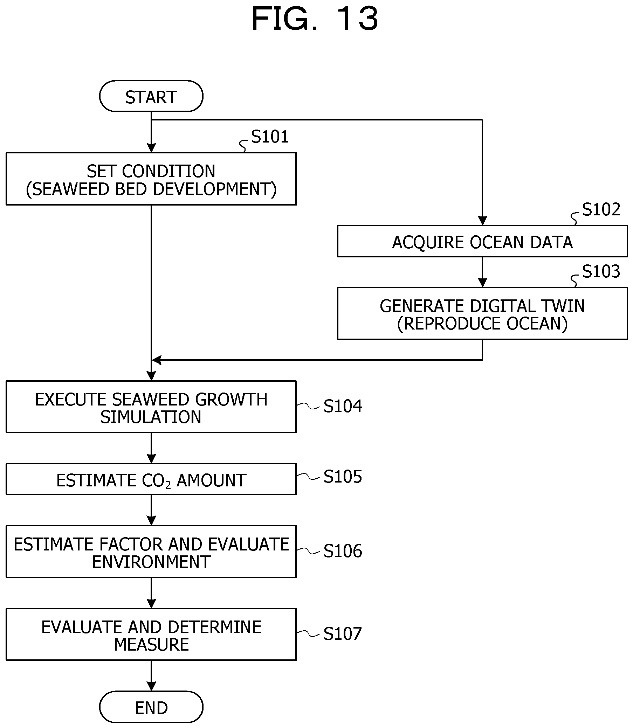

FIG. 13 is a flowchart illustrating a flow of overall processing. As illustrated in FIG. 13, when starting processing by an instruction operation of a user or the like, the information processing device 10 sets various conditions regarding seaweed bed development and generates a development pattern (measure) (S101). On the other hand, the information processing device 10 acquires the ocean data (S102), and generates a digital twin that reproduces the ocean in the real world (S103).

Then, the information processing device 10 executes a seaweed growth simulation, for each measure (S104) and estimates a CO₂ absorption amount using a simulation result (S105).

Thereafter, the information processing device 10 estimates a factor using the classification model, the causal discovery model, or the like and executes an environment evaluation simulation or the like on the digital twin to evaluate the environment information (S106). Then, the information processing device 10 evaluates each measure and determines optimal evaluation (S107).

### (Flow of Simulation Processing)

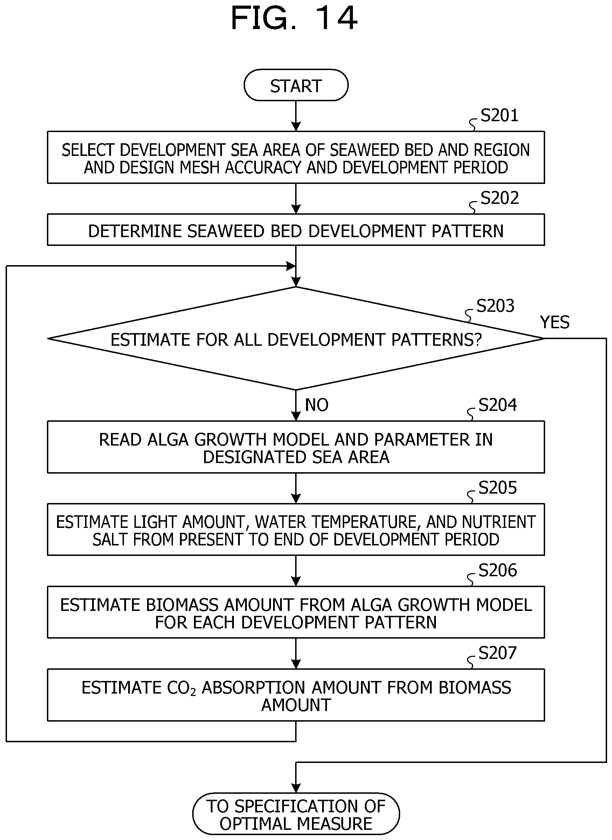

FIG. 14 is a flowchart illustrating a flow of simulation processing. This processing is the diagram for explaining S101 to S105 in FIG. 13 in detail.

As illustrated in FIG. 14, the information processing device 10 receives selection of the development sea area and the region of the seaweed bed and designation of mesh accuracy and the development period (S201) and determines a seaweed bed development pattern that is a measure (S202).

Then, the information processing device 10 executes S203 to S207, on all the development patterns. Specifically, the information processing device 10 reads an alga growth model and a parameter in the designated sea area (S204) and estimates a light amount, a water temperature, and nutrient salt from the present to the end of the development period (S205). Then, the information processing device 10 estimates a biomass amount from the alga growth model for each development pattern (S206) and estimates the CO₂ absorption amount from the biomass amount (S207).

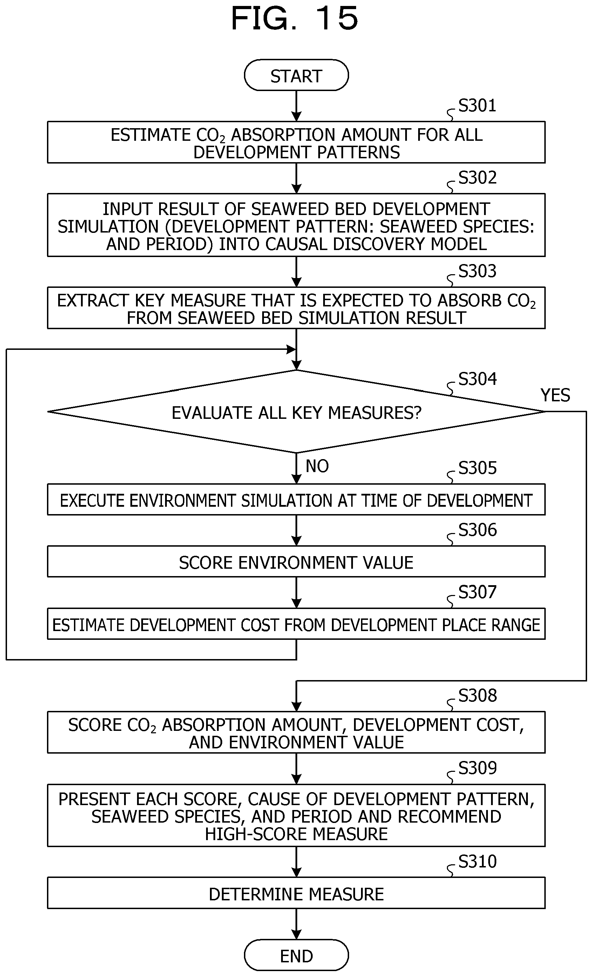

Thereafter, when completing the estimation of the CO₂ absorption amounts for all the development patterns (S203: Yes), the information processing device 10 executes the optimal measure specifying processing illustrated in FIG. 15 (S208).

### (Flow of Measure Evaluation Processing)

FIG. 15 is a flowchart illustrating a flow of measure evaluation processing. This processing is a diagram for explaining details of S107 in FIG. 13.

As illustrated in FIG. 15, when the estimation of the CO₂ absorption amounts for all the development patterns has ended (S301), the information processing device 10 inputs a result of the seaweed bed development simulation (development pattern, seaweed species, and period) into the causal discovery model (S302) and extracts a key measure that is expected to absorb CO₂ from the seaweed bed simulation result (S303).

Then, the information processing device 10 executes processing from S304 to S307 for all the key measures. Specifically, the information processing device 10 executes the environment simulation at the time of development (S305), scores an environment value (S306), and estimates development cost from a range of a development place or the like (S307). Note that the cost may be estimated at the time when the development pattern is generated, and execution at any timing can be made.

Thereafter, the information processing device 10 scores the CO₂ absorption amount, the development cost, and the environment value of all the measures (S308), and presents each score and a cause of the development pattern, the seaweed species, and the period, displays a high-score measure, and recommends the measure to the user (S309). As a result, the user determines whether or not to execute the recommended measure (S310).

### (Effects)

As described above, the information processing device 10 generates the digital twin that reproduces the state of the ocean in the real world on the virtual space, performs the simulation regarding the growth of the seaweeds and the development of the seaweed bed using the state of the ocean with the generated digital twin, and specifies the optimal measure from among the plurality of measure candidates, based on the simulation result. As a result, since the information processing device 10 can reproduce and simulate various conditions on the digital twin, without limitation to a specific condition, the accuracy of the measure analysis can be improved.

Furthermore, since the information processing device 10 can specify which element affects the CO₂ absorption amount, the information processing device 10 can prompt the user to generate an efficient measure. Furthermore, since the information processing device 10 can specify the optimal measure not only in terms of the CO₂ absorption amount but also from complex viewpoint, the information processing device 10 can recommend a measure for each item to be emphasized such as an emphasis on environment or an emphasis on cost and can propose the optimal measure in accordance with a request of the user.

Furthermore, since the information processing device 10 can reproduce not only the actual ocean data but also the predicted future ocean data on the digital twin, the measure selection accuracy can be improved. Furthermore, even under a condition that is not currently assumed, the information processing device 10 can reproduce the condition with the digital twin. Therefore, the information processing device 10 can specify the optimal measure under various conditions, and can specify the optimal measure coping with various patterns such as a situation assumed by the user, an unexpected situation, or the like.

### [Second Embodiment]

Here, a flow of processing of an information processing device 10 according to a second embodiment will be described. The information processing device 10 can specify a measure to be applied to an object positioned in an area, by analyzing an ocean state in time series in the area where the object to which the measure is applied is positioned, in an ocean digital twin. Furthermore, as a measure candidate, various measures using ocean data can be targeted.

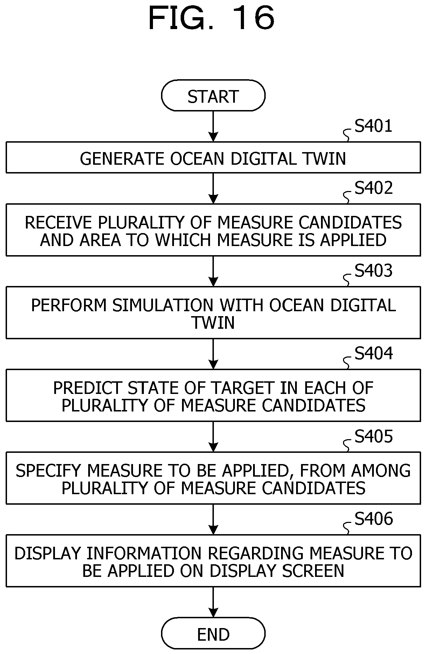

FIG. 16 is a diagram for explaining the flow of the processing for specifying the measure to be applied. As illustrated in FIG. 16, first, the information processing device 10 generates the ocean digital twin. For example, the information processing device 10 generates the digital twin that reproduces an ocean state in the real world in a virtual space, using ocean data measured by a plurality of sensors existing in the ocean. More specifically, a control unit 20 of the information processing device 10 generates a digital twin in which the real world and the virtual space are time-synchronized that is a digital twin that reproduces a state of an ocean for each place in the ocean, using the ocean data (S401).

Next, the information processing device 10 receives the plurality of measure candidates and an area to which the measure is applied. For example, the control unit 20 of the information processing device 10 receives information regarding a type of seaweeds, as the plurality of measure candidates. Furthermore, for example, the control unit 20 of the information processing device 10 receives an area where a seaweed bed is developed, as the area to which the measure is applied (S402).

Then, the information processing device 10 performs a simulation with the ocean digital twin. For example, the information processing device 10 performs a simulation of an ocean state in the area where the object to which the measure is applied is positioned, on the digital twin that reproduces the ocean state. More specifically, the control unit 20 of the information processing device 10 performs the simulation of the ocean state in time series, for example, in the area where the seaweed bed is developed (S403).

Next, the information processing device 10 predicts a state of the object, for each of the plurality of measure candidates. For example, the information processing device 10 predicts a seaweed growing state, for each of a plurality of types of seaweeds, using the simulated ocean state. More specifically, the control unit 20 of the information processing device 10 acquires a machine learning model, for example, using the ocean state as training data and trained as setting the seaweed growing state as correct answer data. Then, the control unit 20 of the information processing device 10 predicts the seaweed growing state, for each type of the seaweed, for example, by inputting the simulated ocean state into the machine learning model trained for each type of the seaweed (S404).

Then, the information processing device 10 specifies a measure to be applied, from among the plurality of measure candidates. For example, the information processing device 10 specifies a measure to be applied to the object positioned in the area where the measure is applied. For example, the information processing device 10 specifies a measure in which a predicted state of the object satisfies a predetermined condition as the measure to be applied. More specifically, the control unit 20 of the information processing device 10 specifies the type of the seaweed used to form a seaweed bed having an area equal to or more than a predetermined area, after growth of the seaweed, for example, in the area where the seaweed bed is developed. Then, the control unit 20 of the information processing device 10 sets, for example, the specified type of the seaweed as a type of a seaweed having the best seaweed growing state (S405).

Then, the information processing device 10 displays information regarding the measure to be applied, on a display screen. For example, the control unit 20 of the information processing device 10 displays information regarding the type of the seaweed having the best seaweed growing state, in the area where the seaweed bed is developed, on the display screen (S406). As a result, since the information processing device 10 can reproduce and simulate various conditions on the ocean digital twin, without limitation to a specific condition, it is possible to specify the measure to be applied, from among the plurality of measure candidates.

### [Third Embodiment]

Although the embodiments have been described above, the present invention may be implemented in various different modes in addition to the embodiments described above.

For example, an information processing device 10 can verify measures regarding an ocean, by simulating a change in an environment included in the ocean, growth of a living object, or the like, in an ocean digital twin. Furthermore, for example, the information processing device 10 can calculate a carbon dioxide absorption amount, in order to verify a measure related to blue carbon. Furthermore, for example, the information processing device 10 can perform a time-series simulation of the growth of the underwater organisms, by incorporating biological knowledges, in the ocean digital twin. As a result, it is possible to simulate a transition of the carbon dioxide absorption amount in a case where a measure for conserving a certain marine ecosystem is taken, including a growth situation of the underwater organisms, in a digital space and verify a global warming countermeasure effect in advance.

### (Numerical Values, etc.)

Numerical values, measure examples, scores, or the like used in the embodiment described above are merely examples and can be arbitrarily changed. In addition, the process flow described in each flowchart may be appropriately modified in a range without inconsistency.

### (Digital Twin)

In the above embodiments, an example has been described where the ocean data is predicted by using the machine learning model on the digital twin. However, the embodiment is not limited to this. For example, the information processing device 10 can directly set a state assumed by the user, a parameter indicating a state that the user desires to simulate (light amount, water temperature, nutritional salt, or the like) to the digital twin, reproduce the state on the digital twin, so as to perform a simulation.

### (Another Example of Measures)

In the above embodiments, an example has been described where the development pattern of the seaweed is simulated as the measure. However, the embodiment is not limited to this, and various measures using the ocean data can be targeted. For example, the information processing device 10 can use a maintenance item for an artificial object such as an offshore wind turbine used for power generation or the like, a building, and a structure, as the measure.

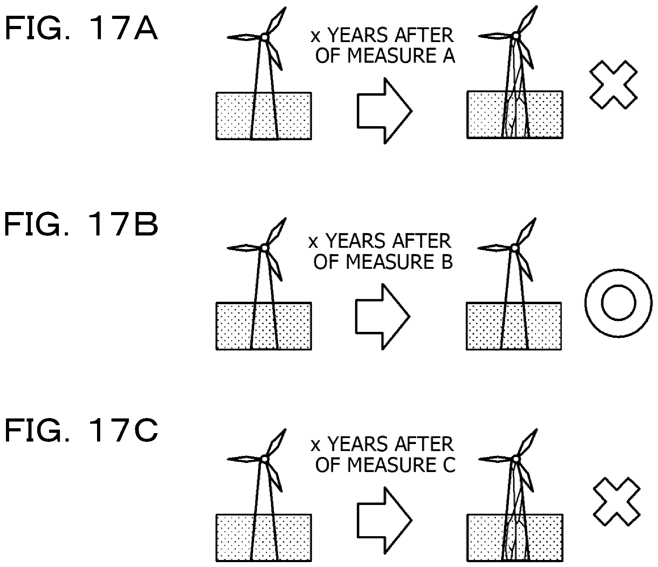

FIGs. 17A to 17C are diagrams for explaining another example of measure evaluation. For example, the information processing device 10 can simulate a state of an offshore wind turbine after X years in a case where maintenance in the measure A is applied on the offshore wind turbine (refer to FIG. 17A), a state of the offshore wind turbine after X years in a case where maintenance in the measure B is applied on the offshore wind turbine (refer to FIG. 17B), and a state of the offshore wind turbine after X years in a case where maintenance in the measure C is applied on the offshore wind turbine (refer to FIG. 17C) with the digital twin and evaluate the results.

### (Measure Target)

In the above embodiments, the sea area has been described as an example. However, the embodiment is not limited to this and can be similarly applied to a fresh water area. Furthermore, not only the seaweeds but also a fresh-water alga can be similarly processed by using a fresh-water alga growth model.

### (System)

Pieces of information including a processing procedure, a control procedure, a specific name, various types of data, and parameters described above or illustrated in the drawings may be also changed in any ways unless otherwise specified.

Furthermore, specific forms of separation and integration of components of each device are not limited to the forms illustrated in the drawings. For example, the ocean model construction unit 40 and the measure determination unit 50 may be integrated. In other words, all or some of the components may be functionally or physically separated or integrated in any units, according to various types of loads, use situations, or the like. Moreover, all or any part of the individual processing functions of each device can be implemented by a central processing unit (CPU) and a program analyzed and executed by the CPU, or can be implemented as hardware by wired logic.

Moreover, all or any part of each processing function performed in each device can be implemented by a CPU and a program analyzed and executed by the CPU or can be implemented as hardware by wired logic.

### (Hardware)

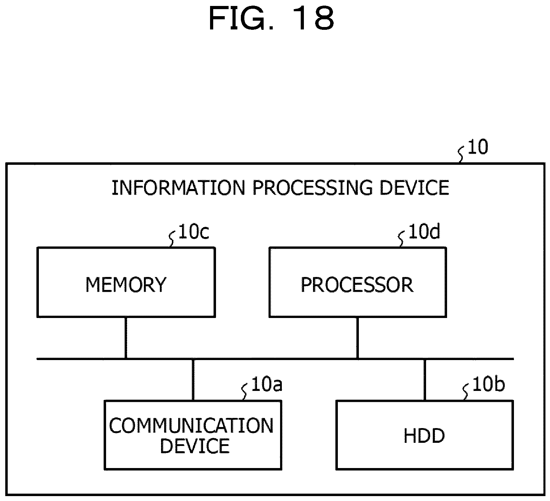

FIG. 18 is a diagram for explaining a hardware configuration example. Here, as an example, the information processing device 10 will be described. As illustrated in FIG. 18, the information processing device 10 includes a communication device 10a, a hard disk drive (HDD) 10b, a memory 10c, and a processor 10d. In addition, the respective units illustrated in FIG. 18 are mutually coupled by a bus or the like.

The communication device 10a is a network interface card or the like, and communicates with another device. The HDD 10b stores a program for operating the functions illustrated in FIG. 3, and a database (DB).

The processor 10d reads, from the HDD 10b or the like, a program that executes processing similar to that of each processing unit illustrated in FIG. 3, and loads it in the memory 10c, thereby operating a process for implementing each function described with reference to FIG. 3 or the like. For example, this process executes functions similar to the respective processing units of the information processing device 10. Specifically, the processor 10d reads a program having functions similar to the data integration base unit 30, the ocean model construction unit 40, the measure determination unit 50, or the like from the HDD10b or the like. Then, the processor 10d executes a process for executing processing similar to the data integration base unit 30, the ocean model construction unit 40, the measure determination unit 50, or the like.

As described above, the information processing device 10 operates as an information processing device that executes a measure specifying method by reading and executing the programs. Furthermore, the information processing device 10 may also implement the functions similar to those in the embodiments described above by reading the program described above from a recording medium by a medium reading device and executing the read program described above. Note that the program referred to in other embodiments is not limited to being executed by the information processing device 10. For example, the embodiments described above may be similarly applied to a case where another computer or server executes the program or a case where these computer and server cooperatively execute the program.

This program may be distributed via a network such as the Internet. In addition, this program may be recorded in a computer-readable recording medium such as a hard disk, a flexible disk (FD), a compact disc read only memory (CD-ROM), a magneto-optical disk (MO), or a digital versatile disc (DVD) and may be executed by being read from the recording medium by a computer.

## Claims

1. A measure specifying program for causing a computer to execute processing comprising:
generating a digital twin that reproduces a state of a water area in a real world on a virtual space;
performing a simulation with the generated digital twin;
specifying a measure to be applied, from among a plurality of measure candidates, based on a result of the performed simulation; and
displaying information regarding the specified measure on a display screen.

2. The measure specifying program according to claim 1, wherein
the generating processing
generates a digital twin that reproduces an ocean state in the real world on the virtual space, and
the specifying processing
specifies a measure to be applied to an object that is positioned in an area, as the measure to be applied, by analyzing a time-series ocean state in the area where the object to which the measure is applied is positioned, with the digital twin that reproduces the ocean state.

3. The measure specifying program according to claim 1, wherein
the generating processing
generates a digital twin that reproduces an ocean state in the real world on the virtual space,
the performing processing
performs a simulation on an ocean state in an area where an object to which the measure is applied is positioned, with the digital twin that reproduces the ocean state, and
the specifying processing
specifies the measure to be applied to the object positioned in the area, based on a result of the simulation of the ocean state.

4. The measure specifying program according to claim 3, wherein
the performing processing
performs the simulation on the ocean state in the area where the object to which the measure is applied is positioned, by using an estimation model, in the digital twin that reproduces the ocean state, and
the specifying processing
predicts a state of the object of each of the plurality of measure candidates, based on the result of the simulation of the ocean state and specifies a measure in which the predicted state of the object satisfies a predetermined condition, as the measure to be applied to the object positioned in the area.

5. The measure specifying program according to claim 4, wherein
the generating processing
estimates a light amount, a water temperature, and a nutrient salt concentration as a future ocean state designated in advance from a current ocean state, by using a digital twin in which the virtual space and the real world are time-synchronized, and
the performing processing
executes the simulation, by using the light amount, the water temperature, and the nutrient salt concentration estimated as the future ocean state.

6. The measure specifying program according to claim 5, wherein
the generating processing
realizes the future ocean state with the digital twin, by inputting information regarding a current ocean state into a machine learning model trained on the digital twin and acquiring information regarding the future ocean state, and
the specifying processing
specifies the measure to be applied to the object, from among the plurality of measure candidates, as the measure to be applied, based on a result of a simulation of the future ocean state.

7. The measure specifying program according to claim 1, wherein
the generating processing
generates a digital twin that reproduces an ocean state in the real world on the virtual space, and
the performing processing
simulates growth of a seaweed developed in a sea area reproduced by the digital twin, by using the digital twin.

8. The measure specifying program according to claim 7, wherein
the measure
is each development pattern that defines a development sea area where a seaweed is developed, a development range where the seaweed is developed, a seaweed species to be developed, and a development period in which the seaweed is developed,
the generating processing
generates the digital twin that reproduces the development sea area designated by each development pattern, and
the performing processing
simulates growth of the seaweed species in each development pattern, by using the digital twin.

9. The measure specifying program according to claim 8, wherein
the performing processing
simulates the growth of the seaweed species in each development pattern, by using the digital twin and
estimates a carbon dioxide absorption amount of the seaweed species in each development pattern, by using a result of the simulation.

10. The measure specifying program according to claim 8, wherein
the performing processing
calculates an environment value in a case where each development pattern is executed by using the digital twin and
evaluates each of the growth of the seaweed, the environment value, and cost of the development pattern, and
the specifying processing
specifies the development pattern with a best evaluation result.

11. The measure specifying program according to claim 9, wherein
the performing processing
scores a carbon dioxide absorption amount for each development pattern by performing normalization so that a maximum value of the carbon dioxide absorption amount of each development pattern to be compared becomes a constant value,
scores each item included in an ocean health index as an environment value of each development pattern, and
performs scoring by using a coefficient set according to a distance from a coast, a seaweed bed area, a seaweed species, and a laying method, as cost of each development pattern, and
the specifying processing
specifies a development pattern of which a total sum of a score for the carbon dioxide absorption amount, a score for the environment value, and a score for the cost is the highest, as an optimal measure.

12. The measure specifying program according to claim 9, wherein
the performing processing
specifies an item that has a causal relationship with the carbon dioxide absorption amount and a combination of the items, from an item defined by each development pattern and a combination of the items, by using a trained causal discovery model.

13. A measure specifying method implemented by a computer, the measure specifying method comprising:
generating a digital twin that reproduces a state of a water area in a real world on a virtual space;
performing a simulation with the generated digital twin;
specifying a measure to be applied, from among a plurality of measure candidates, based on a result of the performed simulation; and
displaying information regarding the specified measure on a display screen.

14. An information processing device comprising:
a control unit configured to
generate a digital twin that reproduces a state of a water area in a real world on a virtual space,
perform a simulation with the generated digital twin,
specify a measure to be applied, from among a plurality of measure candidates, based on a result of the performed simulation, and
display information regarding the specified measure on a display screen.
